# EUROPÄISCHE PATENTANMELDUNG

(11) **EP 1 981 147 A1**
(43) Veröffentlichungstag der Anmeldung: **15.10.2008**
(21) Anmeldenummer: 08007020.4
(22) Anmeldetag: 09.04.2008
(51) Int. Cl.: H02K 1/02, G02B 6/00

(54) **Beleuchtungseinheit mit einer transparenten Trägerplatte und daraufsitzender Leuchtdiode**

(30) Priorität: 11.04.2007 DE 102007017335
(71) Anmelder: FELA Hitzinger GmbH, 78054 Villingen-Schwenningen (DE)
(72) Erfinder: Schlenker, Helmut, 78056 VS-Schwenningen (DE); Jäckle, Günther, 78664 Eschbronn/Locherhof (DE)
(74) Vertreter: Göhring, Robert

(57) **Zusammenfassung**

Die Erfindung betrifft eine Beleuchtungseinheit mit einer transparenten Trägerplatte (10), die auf einer Seite (14) mit elektrischen Leiterbahnen (20) und einer Vielzahl von Bauelementen (30) sowie mindestens einer Leuchtdiode (40), durch welche parallel zur Trägerplatte (10) Licht abstrahlbar ist, versehen ist, wobei auf der Beleuchtungseinheit ein Deckelteil (60) sitzt mit einem Reflektorelement (62), durch welches von der Leuchtdiode (40) parallel zur Trägerplatte (10) gestrahltes Licht (L) in die transparente Trägerplatte (10) umgelenkt wird.

## Beschreibung

Die Erfindung betrifft eine Beleuchtungseinheit mit einer transparenten Trägerplatte gemäß den Merkmalen des Oberbegriffs des Anspruchs 1.

Eine solche Beleuchtungseinheit ist beispielsweise aus DE 198 54 899 C1 bekannt. Die Beleuchtungseinheit besteht im Wesentlichen aus einer transparenten Trägerplatte, die auf einer Seite mit elektrisch leitfähigen Strukturen versehen ist. Oberflächenmontierbare Leuchtdioden, sogenannte Top-LED's, sind mit ihren Anschlüssen in Kontakt mit den leitfähigen Strukturen. Die lichtabstrahlende Seite der Leuchtdioden ist der transparenten Trägerplatte zugewandt. Hierdurch strahlen die Leuchtdioden Licht durch die transparente Trägerplatte. Die transparente Trägerplatte übernimmt neben der Tragefunktion auch eine Schutzfunktion für die Leuchtdioden. Die empfindlichen Lichtaustrittsflächen der Leuchtdioden sind nämlich durch die beschriebene Montage der Leuchtdioden wirksam vor Beschädigungen oder Schmutz geschützt.

Problematisch bei einer derartigen Anordnung von oberflächenmontierten Leuchtdioden ist, dass das ausgestrahlte Licht unmittelbar in die transparente Trägerplatte eindringt und eine Beeinflussung des von der Leuchtdiode abgestrahlten Lichtes nur noch mit verhältnismäßig hohen Aufwand möglich ist. In der genannte Veröffentlichung ist zur Streuung oder Bündelung von der Leuchtdiode stammenden und in die Trägerplatte eingestrahlten Lichtes vorgeschlagen, auf der der Leuchtdiode abgewandten Seite der Trägerplatte eine optische Struktur, z. B.

Rillen, vorzusehen. Eine nachträgliche Bearbeitung der Trägerplatte ist damit unausweichlich.

Die Erfindung hat das Ziel, ebenfalls eine Beleuchtungseinheit mit einer transparenten Trägerplatte und Leuchtdioden anzugeben, bei der allerdings eine Beeinflussung des von der Leuchtdiode abgestrahlten Lichtes in einfacherer Weise möglich ist, ohne die transparente Trägerplatte bearbeiten zu müssen.

Dieses Ziel wird durch eine Beleuchtungseinheit mit den Merkmalen des Anspruchs 1 gelöst.

Weiterbildungen einer solchen Beleuchtungseinheit sind in den Unteransprüchen angegeben.

Die Erfindung beruht im Wesentlichen darauf, als Leuchtdioden sogenannte Side-LED's zu verwenden. Solche seitwärtsabstrahlenden, oberflächenmontierbaren Leuchtdioden strahlen parallel zur Trägerplatte, auf die die Leuchtdioden montiert sind, ihr Licht aus. Erfindungsgemäß sitzt auf der Beleuchtungseinheit mit der transparenten Trägerplatte, die auf einer Seite elektrische Leiterbahnen und eine Vielzahl von Bauelementen sowie mindestens die erwähnte oberflächenmontierbare Leuchtdiode aufweist, ein Deckelteil mit einem Reflektorelement. Das Reflektorelement ist im Deckelteil so angeordnet, dass das von der Leuchtdiode parallel zur Trägerplatte ausgestrahlte Licht in die transparente Trägerplatte umgelenkt wird.

Durch eine solche erfindungsgemäße Beleuchtungseinheit kann das von der Leuchtdiode parallel zur Trägerplatte ausgesandte Licht in beliebiger Art und Weise beeinflusst, z. B. gestreut oder bebündelt werden, bevor es über das Reflektorelement in die transparente Trägerplatte umgelenkt wird. Durch eine Streuung wird erreicht, dass das mehr oder weniger punktförmig von der Leuchtdiode ausgestrahlte Licht ausreichend aufgefächert wird, um z. B. auf der Vorderseite der transparenten Trägerplatte einen ausreichend großen Lichtfleck zu erzeugen. Umgekehrt kann durch geeignete optische Mittel auf der Rückseite der Trägerplatte, also auf der Seite, auf der die elektrischen Bauelemente und die Leuchtdiode sitzen, dafür gesorgt werden, dass der auf der Vorderseite der transparenten Trägerplatte aufscheinende Lichtfleck noch kleiner wird, als der Lichtfleck, der von der Leuchtdiode ausgestrahlt wird. Schließlich ist es auch möglich, durch geeignete optische Mittel nicht nur einen kreisrunden Lichtfleck auf der Vorderseite der transparenten Trägerplatte zu erzeugen, sondern nahezu jede beliebige Gestaltung des Lichtflecks zu erreichen, wenn geeignete optische Mittel zwischen die Lichtaustrittsfläche der Leuchtdiode und der transparenten Trägerplatte angeordnet werden.

Wichtig für die erfindungsgemäße Beleuchtungseinheit ist, dass in dem Deckelteil, der die Rückseite der transparenten Trägerplatte abdeckt, ein geeignetes Reflektorelement eingebaut ist, durch welches das seitlich zur Trägerplatte abgestrahlte Licht der Leuchtdiode in die Trägerplatte umgelenkt wird, vorzugsweise um 90°.

Es hat sich als zweckmäßig erwiesen, das in das Deckelteil separat eingesetzte oder als integraler Bestandteil des Deckelteils ausgebildete Reflektorelement sphärenförmig, z. B. parabelförmig, zu gestalten. Es hat sich darüber hinaus als günstig erwiesen, das Reflektorelement mit einer reflektierenden Schicht, z. B. einer reflektierenden Farbschicht oder einer Metallisierung zu versehen.

In einer Weiterbildung der Erfindung ist vorgesehen, dass das Deckelteil eine kammerförmige Ausnehmung aufweist zur Aufnahme der von der Trägerplatte hervorragenden Leuchtdiode. Neben dieser kammerförmigen Ausnehmung sitzt vorzugsweise das erwähnte Reflektorelement. Dieses Reflektorelement kann in Draufsicht auf die Innenseite des Deckelteils beispielsweise halbkreisförmig gestaltet sein. Das Reflektorelement kann aber auch als ebene Platte, z. B. als ebenes Spiegel ausgebildet sein.

Die auf der Trägerplatte montierte Leuchtdiode kann in eine Kunststoffmasse oder Kunststoffschicht eingebettet sein. Eine solche Kunststoffmasse kann zur diffusen Lichtverteilung des aus der Leuchtdiode abgestrahlten Lichtes eingesetzt werden, um so auf der Vorderseite der transparenten Trägerplatte einen gleichmäßig ausgeleuchteten Lichtfleck zu erzeugen. Die Kunststoffschicht bzw. die Kunststoffmasse kann jedoch auch dazu dienen, dass aus der Leuchtdiode stammende Licht zu filtern, um beispielsweise eine bestimmte Farbe des an der Vorderseite der Trägerplatte erscheinenden Lichtflecks zu erzeugen.

Die erfindungsgemäße Beleuchtungseinheit wird nachfolgend im Zusammenhang mit Figuren anhand von Ausführungsbeispielen näher erläutert. Es zeigen:
- Figur 1: eine Schnittdarstellung eines ersten Ausführungsbeispiels einer Beleuchtungseinheit nach der Erfindung mit einer oberflächenmontierten Leuchtdiode und einem in einem Deckelteil der Beleuchtungseinheit angeordneten und der Leuchtdiode zugeordneten Reflektorelement,
- Figur 2: eine vergrößerte Darstellung der Beleuchtungseinheit in Figur 1 im Bereich der Leuchtdiode und des Reflektorelements, ebenfalls in Schnittdarstellung,
- Figur 3: eine ausschnittsweise Draufsicht auf das Deckelteil von Figur 1 und Figur 2 mit Blick auf die Innenseite des Deckelteils, und
- Figur 4: eine ähnliche Darstellung einer Beleuchtungseinheit wie in Figur 2, wobei jedoch das Reflektorelement als schrägstehende, ebene Fläche gestaltet ist.

In den nachfolgenden Figuren bezeichnen, sofern nicht anders angegeben, gleich Bezugszeichen gleiche Teile mit gleicher Bedeutung.

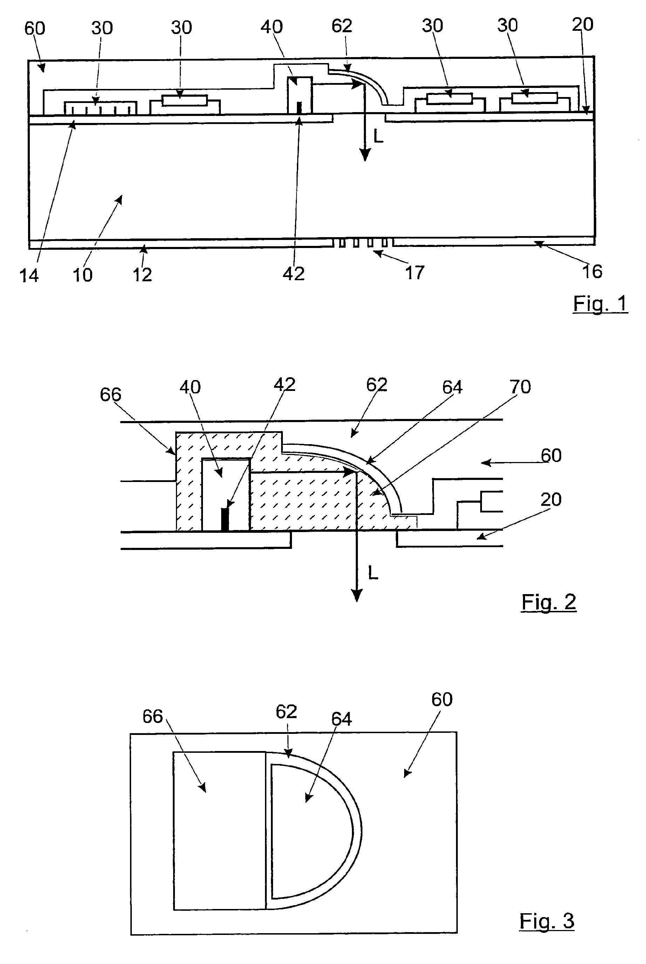

Figur 1 zeigt in stark vereinfachter Weise in Schnittansicht den prinzipiellen Aufbau einer Beleuchtungseinheit nach der Erfindung. Die Beleuchtungseinheit verfügt über eine transparente Trägerplatte 10, die beispielsweise aus Glas oder durchsichtigen Kunststoff bestehen kann. Diese Trägerplatte 10 weist eine erste Seite 12, im vorliegenden ist das die Vorderseite, und eine zweite Seite 14, hier die Rückseite, auf. Auf der ersten Seite 12 ist eine Farbschicht 16 oder ein Dekor aufgebracht mit einem beliebigen, vorgebbaren Symbol 17, das von der zweiten Seite 14 der Trägerplatte 10 her von Licht L durchschienen werden soll. Auf der zweiten Seite 14 der Trägerplatte 10 sind Leiterbahnen 20 aufbracht, z. B. aufgedruckt oder mit einer Leitkleber aufgetragen. Diese Leiterbahnen 20 verbinden eine Vielzahl von elektrischen Bauelementen 30 zur Realisierung einer elektronischen Schaltung.

Um das erwähnte Symbol 17 auf der Vorderseite 12 der Trägerplatte 10 von Licht L zu durchstrahlen, ist eine vorzugsweise oberflächenmontierbare Leuchtdiode 40 auf der zweiten Seite 14 der Trägerplatte platziert. Diese Leuchtdiode 40 weist Kontaktanschlüsse 42 auf, die mit den Leiterbahnen 20 verbunden sind. Die Leuchtdiode 40 ist eine sogenannte Side-LED, die in ihrem montierten Zustand Licht L parallel zur Trägerplatte 10, im Ausführungsbeispiel von Figur 1 nach rechts, abstrahlt.

Auf der Trägerplatte 10 mit der Vielzahl von Bauelementen 30 sitzt ein Deckelteil 60, das bevorzugt aus Kunststoff besteht. Im dargestellten Ausführungsbeispiel deckt dieses Deckelteil 60 die komplette zweite Seite 14 ab. Im Bereich der Leuchtdiode 40 ist in das Deckelteil 60 ein Reflektorelement 62, hier eine Art Parabolspiegel, eingearbeitet, um das von der Leuchtdiode 40 seitlich austretende Licht L um 90° in die Trägerplatte 10 umzulenken, damit das Licht L das Symbol 17 durchscheinen kann. Selbstverständlich ist der Bereich der Trägerplatte 10, der von dem Licht L zu durchstrahlen ist, nicht mit Leiterbahnen 20 bedeckt.

In Figur 2 ist eine vergrößerte Darstellung der Leuchtdiode 40 und des in das Deckelteil 60 integrierten Reflektorelementes 62 dargestellt.

Figur 3 zeigt den zugehörenden Ausschnitt des Deckelteils 60 mit Blick auf die Innenseite des Deckelteils 60. Die aufrechtstehende Leuchtdiode 40 ragt in eine kammerförmige Ausnehmung 66 des Deckelteils 60. Neben dieser kammerförmigen Ausnehmung 66 sitzt das im Querschnitt sphärenförmige Reflektorelement 62. Um eine optimale Umlenkung der von der Leuchtdiode 40 stammenden Lichtstrahlen L zu erreichen, ist das sphärenförmig in das Deckelteil 60 einstückig angeformte Reflektorelement 62 mit einer reflektierenden Beschichtung 64 versehen. Diese reflektierende Beschichtung kann beispielsweise eine weiße Farbschicht oder eine silberfarbene Farbschicht sein. Wie aus Figur 3 deutlich zu erkennen, ist das Reflektorelement 62 in Draufsicht auf die Innenseite des Deckelteils 60 in etwa halbscheibenförmig ausgestaltet.

Die Leuchtdiode 40 sitzt gemäß Figur 2 in einer Kunststoffmasse 70. Die Kunststoffmasse 70 dient beispielsweise dazu, dass aus der Leuchtdiode 40 heraustretende Licht L gleichmäßig auf das Reflektorelement 62 zu leiten.

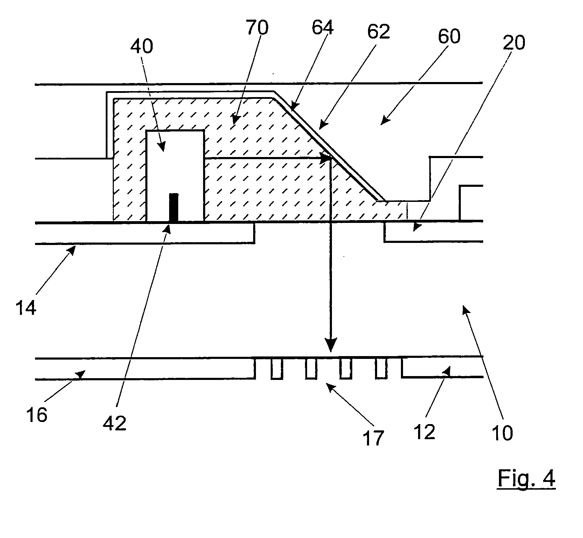

In Figur 4 ist ein weiteres Ausführungsbeispiel einer Beleuchtungseinheit nach der Erfindung dargestellt. Anstelle des im Zusammenhang mit den Figur 1 bis 3 beschriebenen sphärenförmigen Reflektorelements 62 ist hier ein ebenes Reflektorelement 62 im Form eines an eine schräge Innenwand des Deckelteils 60 aufgeklebten oder aufgeclipsten oder aufgeschnappten Spiegels 68 realisiert.

### Bezugszeichenliste

- 10: transparente Trägerplatte
- 12: erste Seite
- 14: zweite Seite
- 16: reflektierende Schicht
- 17: Symbol

- 20: Leiterbahnen
- 30: Bauelemente
- 40: Leuchtdiode
- 42: Kontaktanschluss

- 60: Deckelteil
- 62: Reflektorelement
- 64: reflektierende Beschichtung
- 66: kammerförmige Ausnehmung
- 68: Spiegel

- 70: Kunststoffschicht

- L: Licht

## Patentansprüche

1. Beleuchtungseinheit mit einer transparenten Trägerplatte (10), die auf einer Seite (14) mit elektrischen Leiterbahnen (20) und einer Vielzahl von Bauelementen (30) sowie mindestens einer Leuchtdiode (40), durch welche parallel zur Trägerplatte (10) Licht abstrahlbar ist, versehen ist,
**dadurch gekennzeichnet, dass** auf der Beleuchtungseinheit ein Deckelteil (60) sitzt mit einem Reflektorelement (62), durch welches von der Leuchtdiode (40) parallel zur Trägerplatte (10) gestrahltes Licht (L) in die transparente Trägerplatte (10) umgelenkt wird.

2. Beleuchtungseinheit nach Anspruch 1,
**dadurch gekennzeichnet, dass** das Reflektorelement (62) im Deckelteil (60) das von der Leuchtdiode (40) ausgestrahlte Licht im Wesentlichen um 90° umlenkt.

3. Beleuchtungseinheit nach Anspruch 1 oder 2,
**dadurch gekennzeichnet, dass** das Reflektorelement (62) sphärenförmig gestaltet ist.

4. Beleuchtungseinheit nach einem der Ansprüche 1 bis 3,
**dadurch gekennzeichnet, dass** das Deckelteil (60) eine kammerförmige Ausnehmung (66) zur Aufnahme der von der Trägerplatte (10) hervorstehenden Leuchtdiode (40) aufweist.

5. Beleuchtungseinheit nach Anspruch 4,
**dadurch gekennzeichnet, dass** an die kammerförmige Ausnehmung (66) das Reflektorelement (62) angrenzt.

6. Beleuchtungseinheit nach einem der Ansprüche 1 bis 5,
**dadurch gekennzeichnet, dass** das Reflektorelement (62) in Draufsicht auf eine Innenseite des Deckelteils (60) halbkreisförmig gestaltet ist.

7. Beleuchtungseinheit nach einem der Ansprüche 1 bis 6,
**dadurch gekennzeichnet, dass** das Reflektorelement (62) eine reflektierende Beschichtung (64) aufweist.

8. Beleuchtungseinheit nach einem der Ansprüche 1 bis 7,
**dadurch gekennzeichnet, dass** die Leuchtdiode (40) in eine Kunststoffschicht (70) eingebettet ist.

9. Beleuchtungseinheit nach einem der Ansprüche 1 bis 8,
**dadurch gekennzeichnet, dass** die Leuchtdiode (40) als oberflächenmontierbare Leuchtdiode ausgebildet ist.

10. Beleuchtungseinheit nach einem der Ansprüche 1 bis 9,
**dadurch gekennzeichnet, dass** das Reflektorelement (62) auf der Innenseite des Deckelteils (60) befestigt ist.

11. Beleuchtungseinheit nach einem der Ansprüche 1 bis 9,
**dadurch gekennzeichnet, dass** das Reflektorelement (62) integraler Bestandteil des Deckelteils (60) und dort einstückig angeformt ist.

12. Beleuchtungseinheit nach einem der Ansprüche 1 bis 11,
**dadurch gekennzeichnet, dass** diese eine Vielzahl von auf der Trägerplatte (10) sitzenden Leuchtdioden (40) aufweist, denen jeweils im Deckelteil (60) ein Reflektorelement (62) zugeordnet ist.
